# EUROPEAN PATENT APPLICATION

(11) **EP 4 282 945 A2**
(43) Date of publication of application: **29.11.2023**
(21) Application number: 23175263.5
(22) Date of filing: 25.05.2023
(51) Int. Cl.: C11D 7/26, C11D 7/32, C11D 7/34, C11D 7/50, C11D 11/00, H01L 21/02

(54) **CLEANING COMPOSITION, METHOD OF CLEANING METAL-CONTAINING FILM AND METHOD OF MANUFACTURING SEMICONDUCTOR DEVICE**

(30) Priority: 27.05.2022 KR 20220065552; 23.09.2022 KR 20220121142; 24.05.2023 KR 20230067189
(71) Applicant: Samsung Electronics Co., Ltd., Suwon-si, Gyeonggi-do 16677 (KR)
(72) Inventor: KANG, Byungjoon, 16678 Suwon-si (KR); KIM, Jiwon, 18448 Hwaseong-si (KR); KIM, Sungmin, 16678 Suwon-si (KR); KIM, Hwang Suk, 16678 Suwon-si (KR); OH, Jungmin, 18448 Hwaseong-si (KR); LEE, Hyosan, 18448 Hwaseong-si (KR); CHOI, Byoungki, 16678 Suwon-si (KR); HAM, Cheol, 16678 Suwon-si (KR); HWANG, Kyuyoung, 16678 Suwon-si (KR)
(74) Representative: Elkington and Fife LLP

(57) **Abstract**

Provided are a cleaning composition for removing residues on surfaces, a method of cleaning a metal-containing film by using the same, and a method of manufacturing a semiconductor device by using the same. The cleaning composition comprises a solvent (water), a cleaning accelerator and does not comprise an oxidant.

## Description

### FIELD OF THE INVENTION

The disclosure relates to a cleaning composition for removing residues on surfaces, a method of cleaning a metal-containing film by using the same, and a method of manufacturing a semiconductor device by using the same.

### BACKGROUND OF THE INVENTION

To satisfy requests of consumers for semiconductor devices, i.e., excellent performance and low price, an increase in the degree of integration and improvement in reliability of semiconductor devices are demanded. As the degree of integration of the semiconductor devices increases, damage to components of the semiconductor devices has a greater effect on the reliability and electrical characteristics of semiconductor devices during a manufacturing process thereof. In particular, in the manufacturing process of the semiconductor devices, surface residues generated as a result of surface treatment (e.g., dry etching, etc.) on a predetermined film (e.g., a metal-containing film) may cause exfoliation of a film, which is additionally laminated, or generation of cracks. In addition, various chemical substances may be absorbed or adsorbed on the surface residues through moisture, causing a phenomenon in which a film existing around the surface residues is additionally etched. Therefore, the need for an effective cleaning products and cleaning process, which can remove substantially all of the surface residues, and at the same time, does not cause defects in products including a metal-containing film without damaging the surface of a target film to be cleaned, is continuously increasing.

### SUMMARY OF THE INVENTION

Provided are a cleaning composition, which can provide excellent detergency, and at the same time, does not damage a target film to be cleaned, a method of cleaning a metal-containing film by using the same, and a method of manufacturing a semiconductor device by using the same.

Additional aspects will be set forth in part in the description which follows and, in part, will be apparent from the description, or may be learned by practice of the presented embodiments of the disclosure.

According to an aspect of the disclosure, a cleaning composition for removing residues on surfaces includes
a solvent and a cleaning accelerator, and
does not include an oxidant,
wherein the cleaning accelerator may include at least one of a salt represented by Formula 1A and a salt represented by Formula 1B:

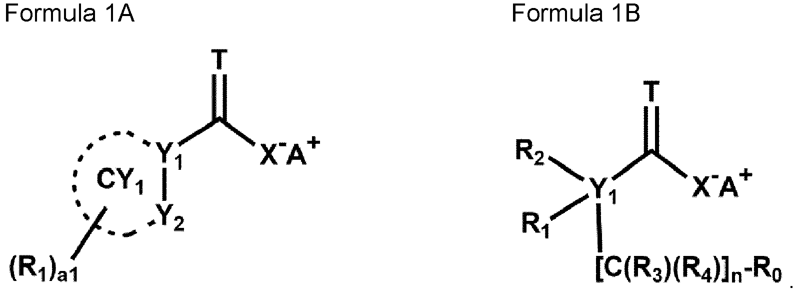

In Formulae 1A and 1B,
T and X may each independently be oxygen (O) or sulfur (S),
A may be N(Q₁)(Q₂)(Q₃)(Q₄) or a metal,
ring CY₁ may be a saturated 5-membered ring, a saturated 6-membered ring, a saturated 7-membered ring, or a saturated 8-membered ring,
Y₁ in Formula 1A may be C(R₁),
Y₁ in Formula 1B may be carbon (C),
Y₂ may be C(R₀)(R₁) or N(R₁),
Y₁ and Y₂ may be linked to each other via a single bond,
R₀ may be *-OH, *-SH, *-C(=O)-OH, *-C(=S)-OH, *-C(=O)-SH, *-C(=S)-SH, or *-N(Q31)(Q32),
R₁ to R₄ may each independently be:
   hydrogen, deuterium, or a halogen atom;
   *-O(Z₁₁), *-S(Z₁₁), *-C(=O)-O(Z₁₁), *-C(=S)-O(Z₁₁), *-C(=O)-S(Z₁₁), *-C(=S)-S(Z₁₁), *-O⁻(Z₁₂)⁺, *-S⁻(Z₁₂)⁺, *-C(=O)-O⁻(Z₁₂)⁺, *-C(=S)-O⁻(Z₁₂)⁺, *-C(=O)-S⁻(Zi₂)⁺, *-C(=S)-S⁻(Z₁₂)⁺, or *-N(R₁₁)(R₁₂), or
   a C₁-C₂₀ alkyl group, a C₁-C₂₀ alkoxy group, a C₆-C₂₀ aryl group, or a C₂-C₂₀ heteroaryl group, unsubstituted or substituted with *-O(Z₂₁), *-S(Z₂₁), *-C(=O)-O(Z₂₁), *-C(=S)-O(Z₂₁), *-C(=O)-S(Z₂₁), *-C(=S)-S(Z₂₁), *-O⁻(Z₂₂)⁺, *-S⁻(Z₂₂)⁺, *-C(=O)-O⁻(Z₂₂)⁺, *-C(=S)-O⁻(Z₂₂)⁺, *-C(=O)-S⁻(Z₂₂)⁺, *-C(=S)-S⁻(Z₂₂)⁺, *-N(R₂₁)(R₂₂), deuterium, a halogen atom, or any combination thereof,
   each of Z₁₁ and Z₂₁ may be hydrogen,
   Z₁₂ may be hydrogen, N(Q₁₁)(Q₁₂)(Q₁₃)(Q₁₄), or a metal,
   Z₂₂ may be hydrogen, N(Q₂₁)(Q₂₂)(Q₂₃)(Q₂₄), or a metal,
   Q1 to Q₄, Q₁₁ to Q₁₄, Q₂₁ to Q₂₄, Q₃₁, Q₃₂, R₁₁, R₁₂, R₂₁, and R₂₂ may each independently be hydrogen, *-[C(R₃₁)(R₃₂)]ₘ-(R₃₃), or a C₆-C₂₀ aryl group,
   R₃₁ to R₃₃ in *-[C(R₃₁)(R₃₂)]ₘ-(R₃₃) may each independently be: hydrogen;
   *-OH, *-SH, *-C(=O)-OH, *-C(=S)-OH, *-C(=O)-SH, *-C(=S)-SH, or *-N(Q₄₁)(Q₄₂); or
   a C₁-C₂₀ alkyl group unsubstituted or substituted with *-OH, *-SH, *-C(=O)-OH, *-C(=S)-OH, *-C(=O)-SH, *-C(=S)-SH, *-N(Q₅₁)(Q₅₂), or any combination thereof,
   m in *-[C(R₃₁)(R₃₂)]ₘ-(R₃₃) may be an integer from 1 to 30,
   at least one *-C(R₃₁)(R₃₂)-*' in *-[C(R₃₁)(R₃₂)]ₘ-(R₃₃) may be optionally substituted with *-O-*', *-S-*' or *-N(R₃₁)-*',
   Q₄₁, Q₄₂, Q₅₁ and Q₅₂ may each independently be hydrogen, a C₁-C₂₀ alkyl group, or a C₆-C₂₀ aryl group,
   n may be 0 or 1,
   a1 may be an integer from 0 to 10, and
   each of * *' indicates a binding site to a neighboring atom.

The solvent in the cleaning composition for removing residues on surfaces may include water.

In Formula 1B, n may be 0.

In Formula 1A, Y₂ may be C(R₀)(R₁), R₀ may be *-OH or *-SH, and R₁ may be hydrogen.

In Formula 1A, Y₂ may be N(R₁), and R₁ may be hydrogen.

In Formula 1B, at least one of R₁ to R₄ may be
*-C(=O)-O(Z₁₁) or *-C(=O)-O⁻(Z₁₂)⁺, or
a C₁-C₂₀ alkyl group substituted with *-C(=O)-O(Z₂₁) or *-C(=O)-O⁻(Z₂₂)⁺,
Z₁₂ may be N(Q₁₁)(Q₁₂)(Q₁₃)(Q₁₄), and
Z₂₂ may be N(Q₂₁)(Q₂₂)(Q₂₃)(Q₂₄).

The cleaning accelerator may further include at least one of a compound represented by Formula 1A(1), a compound represented by Formula 1B(1), a compound represented by Formula 1P-1, and a compound represented by Formula 1P-2:

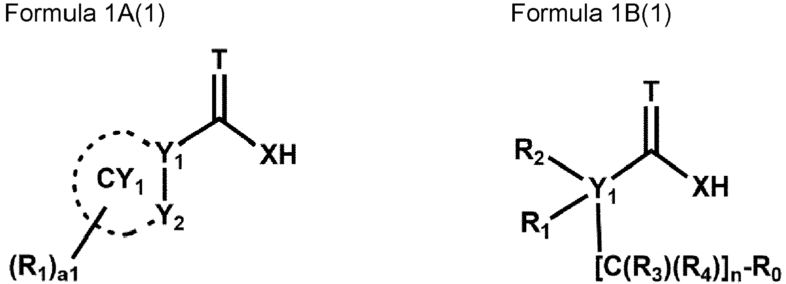

Formula 1P-1 A-OH

Formula 1P-2 N(Q₁)(Q₂)(Q₃)

wherein, T, X, A, ring CY₁, Y₂, R₀ to R₄, Q₁ to Q₃, n, and a1 in Formulae 1A(1), 1B(1), 1P-1, and 1P-2 are each the same as described herein, Y₁ in Formula 1A(1) is the same as described in connection with Y₁ in Formula 1A described herein, and Y₁ in Formula 1B(1) is carbon.

An amount of the cleaning accelerator may be, per 100 wt% of the cleaning composition for removing residues on surfaces, in a range of about 0.01 wt% to about 10 wt%.

The cleaning composition for removing residues on surfaces may further include a pH adjuster.

The cleaning composition for removing residues may not include a fluorine-containing compound and an organic solvent.

The residues on surfaces may be, after a metal-containing film is surface-treated, separated from the metal-containing film and generated on the surface of the metal-containing film, and in this regard, may include a metal derived from the metal-containing film.

The metal-containing film may include aluminum, copper, titanium, tungsten, cobalt, or any combination thereof.

In the cleaning composition for removing residues on surfaces, at least one of an anion represented by Formula 1A(2) and an anion represented by Formula 1B(2) may be linked to a metal atom included in the residues on surfaces, and may not be linked to a metal atom included in the metal-containing film: 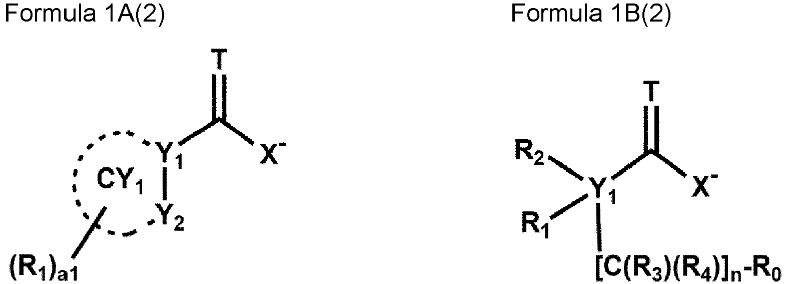 wherein, T, X, ring CY₁, Y₂, R₀ to R₄, n, and a1 in Formulae 1A(2) and 1B(2) are each the same as described herein, Y₁ in Formula 1A(2) is the same as described in connection with Y₁ in Formula 1A described herein, and Y₁ in Formula 1B(2) is carbon.

According to another aspect of the disclosure, a method of cleaning a metal-containing film includes
preparing the cleaning composition for removing residues on surfaces; and
bringing the cleaning composition for removing residues on surfaces into contact with the metal-containing film provided on a substrate, the metal-containing film having a surface on which residues are generated.

The preparing of the cleaning composition for removing residues on surfaces may include preparing the cleaning accelerator by mixing at least one of the compound represented by Formula 1A(1) and the compound represented by Formula 1B(1) with at least one of the compound represented by Formula 1P-1 and the compound represented by Formula 1P-2. Formulae 1A(1), 1B(1), 1P-1 and 1P-2 are the same as described above.

According to another aspect of the disclosure, a method of manufacturing a semiconductor device includes
preparing the cleaning composition for removing residues; and
bringing the cleaning composition for removing residues on surfaces into contact with the metal-containing film provided on a substrate, the metal-containing film having a surface on which residues are generated.

The method of manufacturing a semiconductor device may further include performing subsequent manufacturing process(es) to manufacture a semiconductor device.

### DETAILED DESCRIPTION OF THE EMBODIMENTS

Reference will now be made in detail to embodiments. In this regard, the present embodiments may have different forms and should not be construed as being limited to the descriptions set forth herein. Accordingly, the embodiments are merely described below to explain aspects. As used herein, the term "and/or" includes any and all combinations of one or more of the associated listed items. Expressions such as "at least one of," when preceding a list of elements, modify the entire list of elements and do not modify the individual elements of the list.

### Target film to be cleaned

A target film to be cleaned may include a metal-containing film.

A metal included in the metal-containing film may include an alkali metal (e.g., sodium (Na), potassium (K), rubidium (Rb), cesium (Cs), etc.), an alkaline earth metal (e.g., beryllium (Be), magnesium (Mg), calcium (Ca), strontium (Sr), barium (Ba), etc.), a lanthanide metal (e.g., lanthanum (La), europium (Eu), terbium (Tb), ytterbium (Yb), etc.), a transition metal (e.g., scandium (Sc), yttrium (Y), titanium (Ti), zirconium (Zr), hafnium (Hf), vanadium (V), niobium (Nb), tantalum (Ta), chromium (Cr), molybdenum (Mo), tungsten (W), manganese (Mn), iron (Fe), ruthenium (Ru), osmium (Os), cobalt (Co), rhodium (Rh), nickel (Ni), copper (Cu), silver (Ag), zinc (Zn), etc.), a post-transition metal (e.g., aluminum (Al), gallium (Ga), indium (In), thallium (Tl), tin (Sn), bismuth (Bi), etc.), or any combination thereof.

In an embodiment, the metal-containing film may include In, Ti, Al, Cu, W, Co, La, Sc, Ga, Zn, Hf, or any combination thereof.

In one or more embodiments, the metal-containing film may include Al, Cu, Ti, W, Co, or any combination thereof.

In one or more embodiments, the metal-containing film may include Al.

In one or more embodiments, the metal-containing film may include Ti.

In one or more embodiments, the metal-containing film may include Ti and Al.

In one or more embodiments, the metal-containing film may include a metal nitride-containing film (e.g., a metal nitride film). In one or more embodiments, the metal-containing film may include a titanium nitride-containing film (e.g., a titanium nitride film). The titanium nitride-containing film may further include Cu, In, Al, La, Sc, Ga, Hf, Zn, or any combination thereof.

In one or more embodiments, the metal-containing film may include a metal oxide-containing film (e.g., a metal oxide film). The metal oxide-containing film may include Ti, Cu, Al, La, Sc, Ga, Hf, or any combination thereof. For example, the metal oxide-containing film may include an aluminum oxide-containing film (e.g., an aluminum oxide film), an indium gallium zinc oxide (IGZO)-containing film, and the like.

In one or more embodiments, the metal-containing film may include the metal nitride-containing film and the metal oxide-containing film.

In one or more embodiments, the metal-containing film may further include, in addition to the aforementioned metal, a metalloid (e.g., boron (B), silicon (Si), germanium (Ge), arsenic (As), antimony (Sb), tellurium (Te), etc.), a non-metal(e.g., nitrogen (N), phosphorus (P), oxygen (O), sulfur (S), selenium (Se), etc.), and any combination thereof.

The metal-containing film may have a single-layer structure consisting of two or more types of materials or a multi-layer structure including different materials from each other. For example, the metal-containing film may have i) a single-layer structure consisting of a titanium nitride-containing film (e.g., a titanium nitride film), ii) a double-layer structure consisting of a titanium nitride-containing film, which further includes Al, and a titanium nitride film, or iii) a double-layer structure consisting of a titanium nitride film and a silicon nitride film.

### Cleaning composition for removing residues on surfaces

A cleaning composition may include a solvent and a cleaning accelerator.

In an embodiment, the solvent may include water (e.g., deionized water).

In one or more embodiments, the solvent may include an alcohol (e.g., 2-propanol), optionally in combination with water.

The cleaning accelerator may include at least one of a salt represented by Formula 1A and a salt represented by Formula 1B:

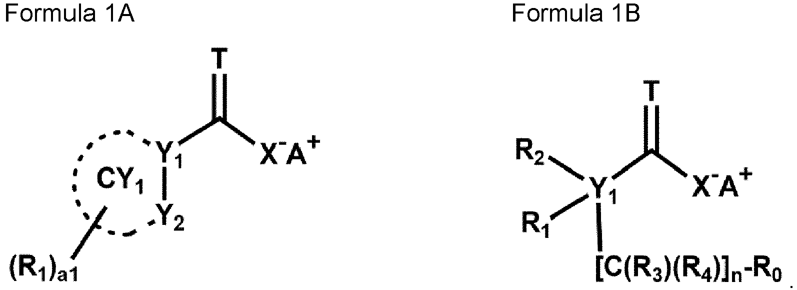

In Formulae 1A and 1B, T and X may each independently be O or S.

In Formulae 1A and 1B, A may be N(Q₁)(Q₂)(Q₃)(Q₄) or a metal (e.g., Na, K, Rb, Cs, etc.). For example, A may be N(Q₁)(Q₂)(Q₃)(Q₄). A may constitute a cation in Formulae 1A and 1B. Q₁ to Q₄ are each the same as described in the present specification.

In Formula 1A, ring CY₁ may be a saturated 5-membered ring, a saturated 6-membered ring, a saturated 7-membered ring, or a saturated 8-membered ring.

For example, ring CY₁ may be a saturated 5-membered ring (e.g., pyrrolidine) or a saturated 6-membered ring (e.g., cyclohexane, piperidine, etc.).

Y₁ in Formula 1A may be C(R₁) and Y₁ in Formula 1B may be carbon (C). Carbon of Y₁ may be alpha (α)-C with respect to a group represented by 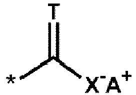 in Formulae 1A and 1B.

In Formula 1A, Y₂ may be C(R₀)(R₁) or N(R₁). R₀ and R₁ are each the same as described in the present specification.

In Formula 1A, Y₁ and Y₂ may be linked to each other via a single bond.

In Formulae 1A and 1B, R₀ may be *-OH, *-SH, *-C(=O)-OH, *-C(=S)-OH, *-C(=O)-SH, *-C(=S)-SH, or *-N(Q₃₁)(Q₃₂).

In Formulae 1A and 1B, R₁ to R₄ may each independently be:
hydrogen, deuterium, or a halogen atom;
*-O(Z₁₁), *-S(Z₁₁), *-C(=O)-O(Z₁₁), *-C(=S)-O(Z₁₁), *-C(=O)-S(Z₁₁), *-C(=S)-S(Z₁₁), *-O⁻(Z₁₂)⁺, *-S⁻(Z₁₂)⁺, *-C(=O)-O⁻(Z₁₂)⁺, *-C(=S)-O⁻(Z₁₂)⁺, *-C(=O)-S⁻(Z₁₂)⁺, *-C(=S)-S⁻(Z₁₂)⁺, or *-N(R₁₁)(R₁₂); or
a C₁-C₂₀ alkyl group, a C₁-C₂₀ alkoxy group, a C₆-C₂₀ aryl group, or a C₂-C₂₀ heteroaryl group, unsubstituted or substituted with *-O(Z₂₁), *-S(Z₂₁), *-C(=O)-O(Z₂₁), *-C(=S)-O(Z₂₁), *-C(=O)-S(Z₂₁), *-C(=S)-S(Z₂₁), *-O⁻(Z₂₂)⁺, *-S⁻(Z₂₂)⁺, *-C(=O)-O⁻(Z₂₂)⁺, *-C(=S)-O⁻(Z₂₂)⁺, *-C(=O)-S⁻(Z₂₂)⁺, *-C(=S)-S⁻(Z₂₂)⁺, *-N(R₂₁)(R₂₂), deuterium, a halogen atom, or any combination thereof.

Here, each of Z₁₁ and Z₂₁ may be hydrogen, Z₁₂ may be hydrogen, N(Q₁₁)(Q₁₂)(Q₁₃)(Q₁₄), or a metal (e.g., Na, K, Rb, Cs, etc.), and Z₂₂ may be hydrogen, N(Q₂₁)(Q₂₂)(Q₂₃)(Q₂₄), or a metal (e.g., Na, K, Rb, Cs, etc.).

In the present specification, Q₁ to Q₄, Q₁₁ to Q₁₄, Q₂₁ to Q₂₄, Q₃₁, Q₃₂, R₁₁, R₁₂, R₂₁, and R₂₂ may each independently be hydrogen, *-[C(R₃₁)(R₃₂)]ₘ-(R₃₃), or a C₆-C₂₀ aryl group.

In *-[C(R₃₁)(R₃₂)]ₘ-(R₃₃), R₃₁ to R₃₃ may each independently be:
hydrogen;
*-OH, *-SH, *-C(=O)-OH, *-C(=S)-OH, *-C(=O)-SH, *-C(=S)-SH, or *-N(Q₄₁)(Q₄₂); or
a C₁-C₂₀ alkyl group unsubstituted or substituted with *-OH, *-SH, *-C(=O)-OH, *-C(=S)-OH, *-C(=O)-SH, *-C(=S)-SH, *-N(Q₅₁)(Q₅₂), or any combination thereof.

In *-[C(R₃₁)(R₃₂)]ₘ-(R₃₃), m indicates numbers of a group represented by *-C(R₃₁)(R₃₂)-*' and may be an integer from 1 to 30, an integer from 1 to 20, an integer from 1 to 20, or an integer from 1 to 5. When m is 2 or greater, two or more of a group represented by *-C(R₃₁)(R₃₂)-*' may be identical to or different from each other.

At least one *-C(R₃₁)(R₃₂)-*' included in *-[C(R₃₁)(R₃₂)]ₘ-(R₃₃) may be optionally substituted with *-O-*', *-S-*' or *-N(R₃₁)-*'. R₃₁ of *-N(R₃₁)-*' is the same as described herein.

Q₄₁, Q₄₂, Q₅₁ and Q₅₂ may each independently be hydrogen, a C₁-C₂₀ alkyl group (e.g., a C₁-C₁₀ alkyl group or C₁-C₅ alkyl group), or a C₆-C₂₀ aryl group (e.g., a phenyl group, a naphthyl group, etc.).

In one or more embodiments, Q₁ to Q₄, Q₁₁ to Q₁₄, Q₂₁ to Q₂₄, Q₃₁, Q₃₂, R₁₁, R₁₂, R₂₁, and R₂₂ may each be hydrogen.

In one or more embodiments, at least one of Q₁ to Q₃, at least one of Q₁₁ to Q₁₃, or at least one of Q₂₁ to Q₂₃ may each be *-[C(R₃₁)(R₃₂)]ₘ-(R₃₃).

In one or more embodiments, in *-[C(R₃₁)(R₃₂)]ₘ-(R₃₃), m may be 5, one *-C(R₃₁)(R₃₂)-*' among five *-C(R₃₁)(R₃₂)-*'s may be substituted with *-O-*', each of R₃₁ and R₃₂ may be hydrogen, and R₃₃ may be *-OH. For example, *-[C(R₃₁)(R₃₂)]ₘ-(R₃₃) may be *-CH₂CH₂OCH₂CH₂OH as shown in Compound 2a described below.

In one or more embodiments, in *-[C(R₃₁)(R₃₂)]ₘ-(R₃₃), m may be an integer from 1 to 5, each of R₃₁ and R₃₂ may be hydrogen, and R₃₃ may be *-NH₂. For example, *-[C(R₃₁)(R₃₂)]ₘ-(R₃₃) may be *-CH₂CH₂NH₂ as shown in Compound 2b described below.

In Formula 1B, n may be 0 or 1. When n is 0, R₀ may be directly linked to Y₁.

In Formula 1A, a1 may be an integer from 0 to 10, for example, an integer from 0 to 8 or an integer from 0 to 6.

In the present specification, each of * and *' indicates a binding site to a neighboring atom, unless otherwise indicated.

In an embodiment, in Formula 1A,
Y₂ may be C(R₀)(R₁),
R₀ may be *-OH or *-SH, and
R₁ may be hydrogen.

In one or more embodiments, in Formula 1A,
Y₂ may be N(R₁), and
R₁ may be hydrogen.

In one or more embodiments, at least one of R₁ to R₄ in Formula 1B may be:
*-C(=O)-O(Z₁₁) or *-C(=O)-O⁻(Z₁₂)⁺; or
a C₁-C₂₀ alkyl group substituted with *-C(=O)-O(Z₂₁) or *-C(=O)-O⁻(Z₂₂)⁺,
Z₁₂ may be N(Q₁₁)(Q₁₂)(Q₁₃)(Q₁₄), and
Z₂₂ may be N(Q₂₁)(Q₂₂)(Q₂₃)(Q₂₄).

In one or more embodiments, in Formula 1B,
n may be 0, and
R₀ may be *-OH, *-SH, or *-NH₂.

In one or more embodiments, in Formula 1B, R₁ may be hydrogen.

In one or more embodiments, in Formula 1B, R₂ may be hydrogen; a unsubstituted C₁-C₅ alkyl group; or a C₁-C₅ alkyl group substituted with *-OH, *-SH, *-C(=O)-O(Z₂₁), *-C(=O)-O⁻(Z₂₂)⁺, *-NH₂, or any combination thereof.

The variable definitions as described herein can be combined in any combination that results in a stable compound.

In one or more embodiments, the cleaning accelerator may not include ammonium citrate and ammonium lactate.

In one or more embodiments, the cleaning accelerator may further include at least one of a compound represented by Formula 1A(1), a compound represented by Formula 1B(1), a compound represented by Formula 1P-1, and a compound represented by Formula 1P-2:

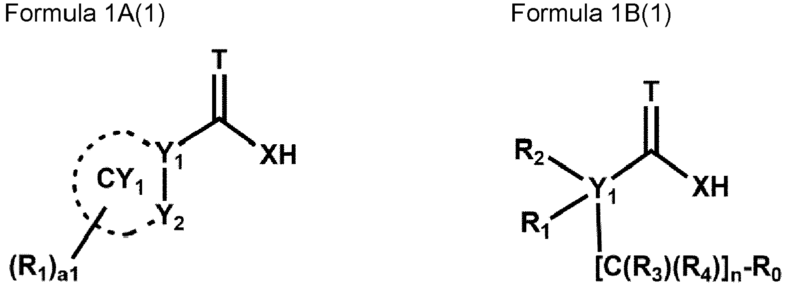

Formula 1P-1 A-OH

Formula 1P-2 N(Q₁)(Q₂)(Q₃)

wherein, T, X, A, ring CY₁, Y₂, R₀ to R₄, Q₁ to Q₃, n, and a1 in Formulae 1A(1), 1B(1), 1P-1, and 1P-2 are each the same as described herein, Y₁ in Formula 1A(1) is the same as described in connection with Y₁ in Formula 1A described herein, and Y₁ in Formula 1B(1) is carbon.

The compound represented by Formula 1A(1), the compound represented by Formula 1B(1), the compound represented by Formula 1P-1, and the compound represented by Formula 1P-2 may be unreacted compounds at the time of preparing the cleaning accelerator, which will be described below.

The compound represented by Formula 1P-1 may be NH₄OH, NaOH, KOH, etc.

The compound represented by Formula 1P-2 may be diglycolamine (NH₂CH₂CH₂OCH₂CH₂OH), ethylenediamine (NH₂CH₂CH₂NH₂), etc.

In one or more embodiments, the cleaning accelerator may include at least one of salts represented by Formulae 1C to 13C:

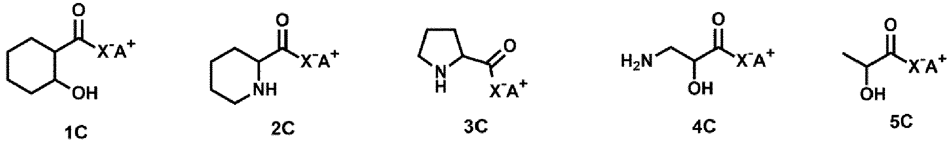

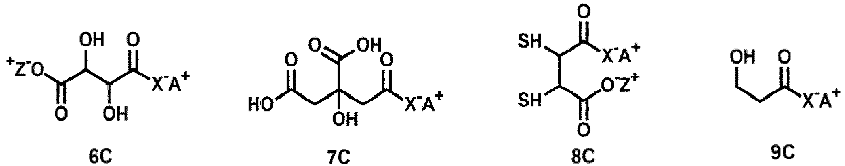

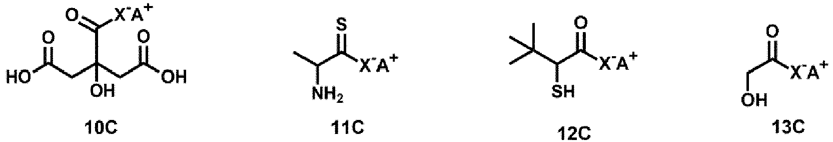

In Formulae 1C to 13C,
X and A are each the same as described in the present specification,
Z may be hydrogen or N(Q₂₁)(Q₂₂)(Q₂₃)(Q₂₄), and
Q₂₁ to Q₂₄ may each be the same as described herein.

In one or more embodiments, the cleaning accelerator may not include a salt represented by Formula 5C, a salt represented by Formula 7C, and a salt represented by Formula 10C.

In one or more embodiments, the cleaning accelerator may further include at least one of compounds represented by Formulae 1D to 13D: 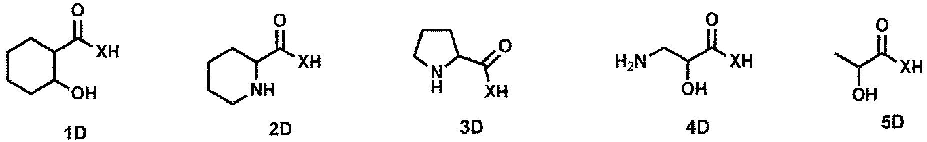 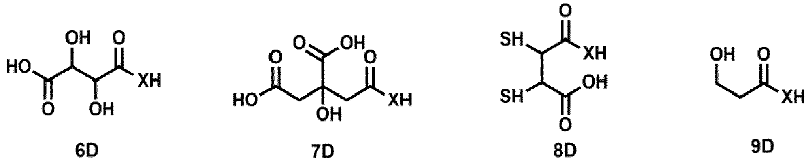 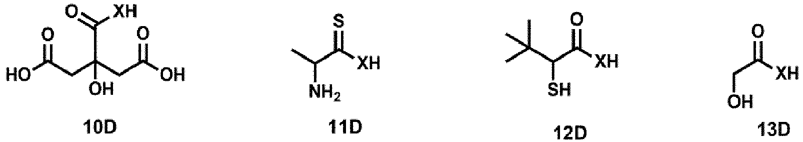 wherein X in Formulae 1D to 13D is the same as described in the present specification.

An amount of the cleaning accelerator may be, per 100 wt% of the cleaning composition for removing residues on surfaces, in a range of about 0.01 wt% to about 10 wt%, about 0.01 wt% to about 5 wt%, or about 0.5 wt% to about 2 wt%. When the amount of the cleaning accelerator is within the ranges above, the residues on surfaces may be effectively removed and damage to the surface of a target film to be cleaned may be also minimized.

The cleaning composition may further include a pH adjuster in addition to the solvent and the cleaning accelerator. The pH adjuster may include, for example ammonium hydroxide (NH₄OH), ammonium hydroxide substituted with at least one C₁-C₂₀ alkyl group, or any combination thereof.

An amount of the pH adjuster may be, per 100 wt% of the cleaning composition for removing residues on surfaces, in a range of about 0.01 wt% to about 10 wt%, about 0.01 wt% to about 5 wt%, or about 0.5 wt% to about 2 wt%. When the amount of the pH adjuster is satisfied with the ranges above, the pH of the cleaning composition may be maintained at an appropriate level. For example, the cleaning composition may have a pH of 8 or less, for example, a pH from 1 to 8.

The cleaning composition may not include an oxidant, a fluorine-containing compound, and an organic solvent. The oxidant may damage the surface of a target film to be cleaned during cleaning, and the fluorine-containing compound and the organic solvent may interfere with the pH control of the cleaning composition.

In an embodiment, the cleaning accelerator may include (or consists of) the salt represented by Formula 1A.

In one or more embodiments, the cleaning accelerator may include (or consists of):
i) the salt represented by Formula 1A; and
ii) at least one of the compound represented by Formula 1A(1), the compound represented by Formula 1P-1, and the compound represented by Formula 1P-2.

In one or more embodiments, the cleaning accelerator may include (or consists of) the salt represented by Formula 1B.

In one or more embodiments, the cleaning accelerator may include (or consists of):
i) the salt represented by Formula 1B; and
ii) at least one of the compound represented by Formula 1B(1), the compound represented by Formula 1P-1, and the compound represented by Formula 1P-2.

In one or more embodiments, the cleaning accelerator may include (or consists of) the salt represented by Formula 1A and the salt represented by Formula 1B.

In one or more embodiments, the cleaning accelerator may include (or consists of):
i) the salt represented by Formula 1A and the salt represented by Formula 1B; and
ii) at least one of the compound represented by Formula 1A(1), the compound represented by Formula 1B(1), the compound represented by Formula 1P-1, and the compound represented by Formula 1P-2.

The residues on surfaces to be removed by the cleaning composition described in the present specification may refer to, after a target film to be cleaned, e.g., a metal-containing film, is surface-treated (e.g., dry etching-treated), residues separated from the metal-containing film and generated on the surface of the metal-containing film.

In an embodiment, the residues on surfaces may include a metal derived from the metal-containing film (e.g., Al, Cu, Ti, W, Co, or any combination thereof).

In one or more embodiments, the metal-containing film may include Al, Cu, Ti, W, Co, or any combination thereof.

In the cleaning composition for removing residues on surfaces, at least one of an anion represented by Formula 1A(2) and an anion represented by Formula 1B(2) may be linked to an atom e.g., a metal atom (e.g., a titanium atom, an aluminum atom, a copper atom, etc.) included in the residues on surfaces, and may not be linked to an atom, e.g., a metal atom, included in a target film to be cleaned, e.g., the metal-containing film: 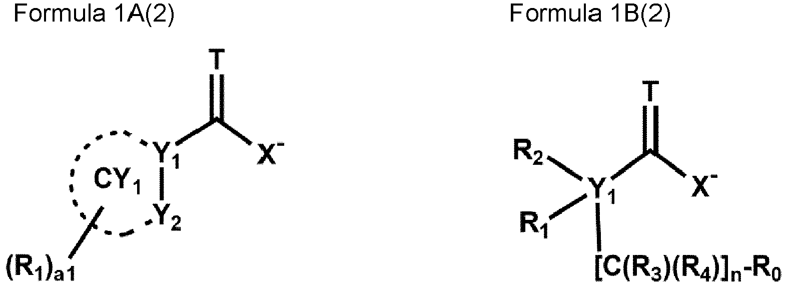 wherein, T, X, ring CY₁, Y₂, R₀ to R₄, n, and a1 in Formulae 1A(2) and 1B(2) are each the same as described herein, Y₁ in Formula 1A(2) is the same as described in connection with Y₁ in Formula 1A described herein, and Y₁ in Formula 1B(2) is carbon.

Therefore, the cleaning composition described in the present specification is clearly distinguished from an "etching" composition that removes atoms included in a target film, for example, atoms that are linked to each other via chemical bonds and included in a target film.

For example, each of Y₂ in Formula 1A and R₀ in Formula 1B may be linked to, together with X⁻ in Formulae 1A and 1B, a metal atom included in the residues on surfaces rather than a metal atom included in the metal-containing film, so as to form a 5-membered cyclometallated ring or a 6-membered cyclometallated ring. In this regard, the metal atom included in the residues on surfaces may be effectively bound such as hydrated or the like. Accordingly, damage to the surface of the metal-containing film which is a target film to be cleaned may be minimized, and at the same time, the residues on surfaces may be effectively removed.

In addition, A constituting the cation in Formulae 1A and 1B may be N(Q₁)(Q₂)(Q₃)(Q₄) or a metal. That is, A⁺ in Formulae 1A and 1B is not H⁺ so that a reaction rate with a metal atom included in the residues on surfaces may be increased to obtain an excellent cleaning effect.

### Method of cleaning metal-containing film and method of manufacturing semiconductor device

A method of cleaning the metal-containing film may include:
preparing the cleaning composition for removing residues on surfaces described in the present specification; and
bringing the cleaning composition for removing residues on surfaces into contact with a metal-containing film provided on a substrate, the metal-containing film having a surface on which residues are generated.

A method of manufacturing a semiconductor device may include:
preparing the cleaning composition for removing residues on surfaces described in the present specification; and
bringing the cleaning composition for removing residues on surfaces into contact with a metal-containing film provided on a substrate, the metal-containing film having a surface on which residues are generated.

The method of manufacturing a semiconductor device may further include performing subsequent manufacturing process(es) to manufacture a semiconductor device.

The residues on surfaces and the metal-containing film are each the same as described in the present specification.

In an embodiment, the preparing of the cleaning composition for removing residues on surfaces may include preparing the cleaning accelerator by mixing at least one of the compound represented by Formula 1A(1) and the compound represented by Formula 1B(1) with at least one of the compound represented by Formula 1P-1 and the compound represented by Formula 1P-2. When the compound represented by Formula P-2 is used in the preparing of the cleaning composition for removing residues on surfaces, A in Formulae 1A and 1B may be N(Q₁)(Q₂)(Q₃)(Q₄) and Q₄ in the N(Q₁)(Q₂)(Q₃)(Q₄) may be hydrogen.

In an embodiment, the compound represented by Formula 1A(1) may be mixed with the compound represented by Formula 1P-1 (for example, NH₄OH) to prepare a cleaning accelerator including the salt represented by Formula 1A, and then, the cleaning accelerator may be mixed with the aforementioned solvent or the like to prepare a cleaning composition for removing residues on surfaces. Here, the cleaning accelerator may further include, as an unreacted reactant, at least one of the compound represented by Formula 1A(1) and the compound represented by Formula 1P-1.

In an embodiment, the compound represented by Formula 1A(1) may be mixed with the compound represented by Formula 1P-2 (for example, NH₂CH₂CH₂OCH₂CH₂OH, NH₂CH₂CH₂NH₂) to prepare a cleaning accelerator including the salt represented by Formula 1A, and then, the cleaning accelerator may be mixed with the aforementioned solvent or the like to prepare a cleaning composition for removing residues on surfaces. Here, the cleaning accelerator may further include, as an unreacted reactant, at least one of the compound represented by Formula 1A(1) and the compound represented by Formula 1P-2.

In one or more embodiments, the compound represented by Formula 1B(1) (for example, Compound 2') may be mixed with the compound represented by Formula 1P-1 (for example, NH₄OH) to prepare a cleaning accelerator including the salt represented by Formula 1B (for example, Compound 2), and then, the cleaning accelerator may be mixed with the aforementioned solvent or the like to prepare a cleaning composition for removing residues on surfaces. Here, the cleaning accelerator may further include, as an unreacted reactant, at least one of the compound represented by Formula 1B(1) and the compound represented by Formula 1P-1.

In one or more embodiments, the compound represented by Formula 1B(1) (for example, Compound 2') may be mixed with the compound represented by Formula 1P-2 (for example, NH₂CH₂CH₂OCH₂CH₂OH or NH₂CH₂CH₂NH₂) to prepare a cleaning accelerator including the salt represented by Formula 1B (for example, Compound 2a or Compound 2b), and then, the cleaning accelerator may be mixed with the aforementioned solvent or the like to prepare a cleaning composition for removing residues on surfaces. Here, the cleaning accelerator may further include, as an unreacted reactant, at least one of the compound represented by Formula 1B(1) and the compound represented by Formula 1P-2.

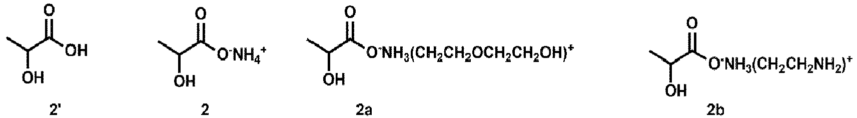

When the cleaning composition for removing residues on surfaces is brought into contact with the metal-containing film provided on a substrate, the metal-containing film having a surface on which residues are generated, at least one of the anion represented by Formula 1A(2) and the anion represented by Formula 1B(2) may be linked to a metal atom included in the residues on the surface of the metal-containing film, and may not be linked to a metal atom included in the metal-containing film.

Meanwhile, the method of cleaning the metal-containing film and the method of manufacturing the semiconductor device may further include washing the metal-containing film provided on the substrate using an additional solvent, and may optionally further include removing the additional solvent by drying the metal-containing film, and optionally the substrate.

### Examples 1 to 3 and Comparative Examples 1 to 6

A solvent was mixed with a cleaning accelerator (1 wt%) and a pH adjuster (1 wt%), and/or an oxidant (20 wt%), if present, shown in Table 1 to prepare cleaning compositions of Examples 1 to 3 and Comparative Examples 1 to 6. Here, deionized water was used as the solvent, and an amount of the solvent corresponds to the remainder per 100 wt% of the cleaning composition. For Compounds 1 to 3 and A to D used as the cleaning accelerators, commercially available compounds were used.

Each of the prepared cleaning compositions was placed in a beaker and heated until the temperature raised to 70 °C, and a plasma-etched titanium/aluminum nitride film was immersed in each of the resulting cleaning compositions for 5 minutes. Then, an ellipsometer, a sheet resistance meter, an X-ray fluorescence (XRF) apparatus, and an X-ray reflectometry (XRR) apparatus were used to evaluate an etching speed during the immersion, and results thereof are shown in Table 1. Next, the titanium/aluminum nitride film was placed out, cleaned with deionized water, and dried under a nitrogen atmosphere. Then, a transmission electron microscope (TEM) apparatus was used to determine whether residues on surfaces remained on the surface of the film, and accordingly, detergency for the residues on surfaces was evaluated, and results thereof are shown in Table 1. The titanium/aluminum nitride film refers to a titanium nitride-containing film further including aluminum.

**Table 1**

| | Cleaning accelerator | pH adjuster | Oxidant | Detergency for residues on surfaces | Etching speed of titanium/aluminum nitride film (Å/min) |
|---|---|---|---|---|---|
| Example 1 | 1 | - | - | O | < 5 |
| Example 2 | 2 | - | - | O | < 5 |
| Example 3 | 3 | Ammonium hydroxide (NH₄OH) | - | O | < 5 |
| Comparative Example 1 | A | - | - | Δ | < 5 |
| Comparative Example 2 | B | - | - | Δ | < 5 |
| Comparative Example 3 | C | - | - | X | < 5 |
| Comparative Example 4 | D | - | - | Δ | < 5 |
| Comparative Example 5 | 1 | - | H₂O₂ | O | 75 |
| Comparative Example 6 | A | - | H₂O₂ | O | 90 |

| | | | | | |
|---|---|---|---|---|---|
| O in detergency for residues on surfaces : Residues on surfaces are completely removed under cleaning performance conditions Δ in detergency for residues on surfaces : Residues on surfaces are slightly removed under cleaning performance conditions X in detergency for residues on surfaces : Residues on surfaces are hardly removed under cleaning performance conditions | | | | | |

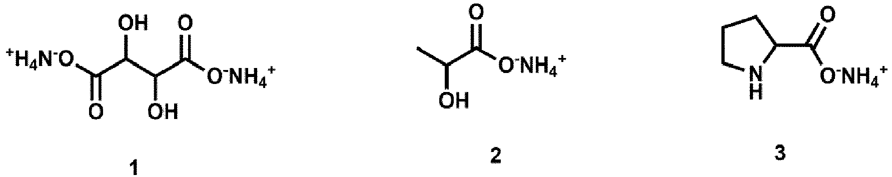

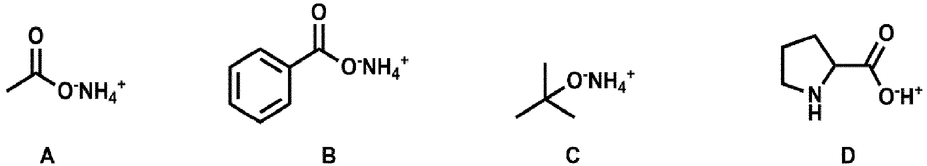

Referring to Table 1, it was confirmed that the cleaning compositions of Comparative Examples 1 to 4 did not substantially damage the surface of a target film under the cleaning performance conditions above, but had poor detergency, whereas the cleaning compositions of Comparative Examples 5 and 6 had excellent detergency, but damaged the surface of a target film under the cleaning performance conditions above. Meanwhile, it was confirmed that the cleaning compositions of Examples 1 to 3 did not substantially damage the surface of a target film under the cleaning performance conditions above, and at the same time, had excellent detergency.

### Examples 11 to 14 and Comparative Example 11

A solvent was mixed with a cleaning accelerator (1 wt%) and a pH adjuster (1 wt%) shown in Table 2 to prepare cleaning compositions of Examples 11 to 13 and Comparative Example 11. Here, deionized water was used as the solvent, and an amount of the solvent corresponds to the remainder per 100 wt% of the cleaning composition. Compounds 1, 2, 4, and A as the cleaning accelerators were each prepared in situ for use by mixing each of Compounds 1', 2', 4', and A' with NH₄OH in equal molar amounts and Compound 2a as the cleaning accelerators was prepared in situ for use by mixing Compound 2' with NH₂CH₂CH₂OCH₂CH₂OH in equal molar amounts.

Subsequently, in the same manner as in Example 1, the etching speed and detergency for the residues on surfaces were evaluated with respect to the cleaning compositions of Examples 11 to 14 and Comparative Example 11, and results thereof are shown in Table 2. The titanium/aluminum nitride film in Table 2 refers to a titanium nitride-containing film further including aluminum.

**Table 2**

| | Cleaning accelerator | pH adjuster | Detergency for residues on surfaces | Etching rate of titanium/al uminum nitride film (Å/min) |
|---|---|---|---|---|
| Example 11 | 1 (1'+ NH₄OH) | NH₄OH | O | < 5 |
| Example 12 | 2 (2'+ NH₄OH) | NH₄OH | O | < 5 |
| Example 13 | 4 (4'+ NH₄OH) | NH₄OH | O | < 5 |
| Example 14 | 2 (2'+ NH₂CH₂CH₂OCH₂CH₂OH) | NH₄OH | O | <5 |
| Comparative Example 11 | A (A'+ NH₄OH) | NH₄OH | △ | < 5 |

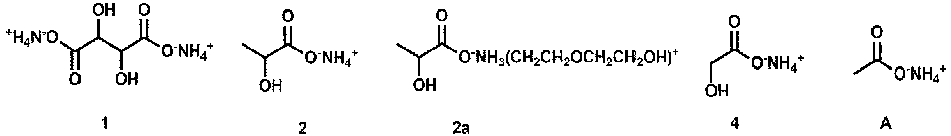

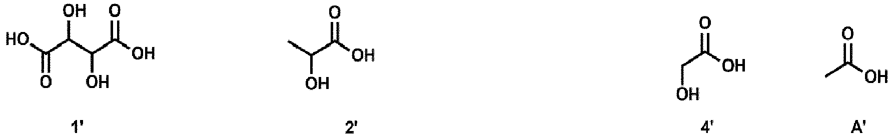

Referring to Table 2, it was confirmed that the cleaning composition of Comparative Example 11 did not substantially damage the surface of a target film to be cleaned under the cleaning performance conditions above, but had poor detergency, whereas the cleaning compositions of Examples 11 to 14 did not substantially damage the surface of a target film to be cleaned under the cleaning performance conditions above, and at the same time, had excellent detergency. According to the one or more embodiments, a cleaning composition has excellent performance of removal of residues on surfaces, and at the same time, does not damage a surface of a target film to be cleaned, and thus, by using the cleaning composition, the surface of a metal-containing film may be effectively cleaned and a high-performance semiconductor device may be manufactured.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described, it will be understood by those of ordinary skill in the art that various changes in form and details may be made therein without departing from the scope as defined by the following claims.

## Claims

1. A cleaning composition for removing residues on surfaces comprising a solvent and a cleaning accelerator, and
not comprising an oxidant,
wherein the cleaning accelerator comprises at least one of a salt represented by Formula 1A and a salt represented by Formula 1B: 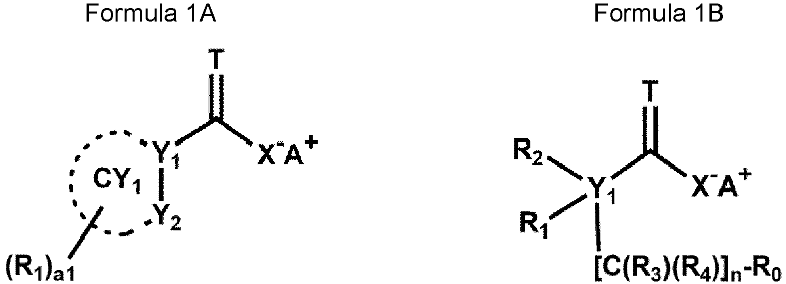
wherein, in Formulae 1A and 1B,
T and X are each independently oxygen (O) or sulfur (S),
A is N(Q₁)(Q₂)(Q₃)(Q₄) or a metal,
ring CY₁ is a saturated 5-membered ring, a saturated 6-membered ring, a saturated 7-membered ring, or a saturated 8-membered ring,
Y₁ in Formula 1A is C(R₁),
Y₁ in Formula 1B is carbon (C),
Y₂ is C(R₀)(R₁) or N(R₁),
Y₁ and Y₂ are linked to each other via a single bond,
R₀ is *-OH, *-SH, *-C(=O)-OH, *-C(=S)-OH, *-C(=O)-SH, *-C(=S)-SH, or *-N(Q31)(Q32),
R₁ to R₄ are each independently:
hydrogen, deuterium, or a halogen atom;
*-O(Z₁₁), *-S(Z₁₁), *-C(=O)-O(Z₁₁), *-C(=S)-O(Z₁₁), *-C(=O)-S(Z₁₁ ), *-C(=S)-S(Z₁₁), *-O⁻(Z₁₂)⁺, *-S⁻(Z₁₂)⁺, *-C(=O)-O⁻(Z₁₂)⁺, *-C(=S)-O⁻(Z₁₂)⁺, *-C(=O)-S⁻(Z₁₂)⁺, *-C(=S)-S⁻(Z₁₂)⁺, or *-N(R₁₁)(R₁₂); or
a C₁-C₂₀ alkyl group, a C₁-C₂₀ alkoxy group, a C₆-C₂₀ aryl group, or a C₂-C₂₀ heteroaryl group, unsubstituted or substituted with *-O(Z₂₁), *-S(Z₂₁), *-C(=O)-O(Z₂₁), *-C(=S)-O(Z₂₁), *-C(=O)-S(Z₂₁), *-C(=S)-S(Z₂₁), *-O⁻(Z₂₂)⁺, *-S⁻(Z₂₂)⁺, *-C(=O)-O⁻(Z₂₂)⁺, *-C(=S)-O⁻(Z₂₂)⁺, *-C(=O)-S⁻(Z₂₂)⁺, *-C(=S)-S⁻(Z₂₂)⁺, *-N(R₂₁)(R₂₂), deuterium, a halogen atom, or any combination thereof,
each of Z₁₁ and Z₂₁ are hydrogen,
Z₁₂ is hydrogen, N(Q₁₁)(Q₁₂)(Q₁₃)(Q₁₄), or a metal,
Z₂₂ is hydrogen, N(Q₂₁)(Q₂₂)(Q₂₃)(Q₂₄), or a metal,
Q1 to Q₄, Q₁₁ to Q₁₄, Q₂₁ to Q₂₄, Q₃₁, Q₃₂, R₁₁, R₁₂, R₂₁, and R₂₂ are each independently hydrogen, *-[C(R₃₁)(R₃₂)]ₘ-(R₃₃), or a C₆-C₂₀ aryl group,
R₃₁ to R₃₃ in *-[C(R₃₁)(R₃₂)]ₘ-(R₃₃) are each independently: hydrogen;
*-OH, *-SH, *-C(=O)-OH, *-C(=S)-OH, *-C(=O)-SH, *-C(=S)-SH, or *-N(Q₄₁)(Q₄₂); or
a C₁-C₂₀ alkyl group unsubstituted or substituted with *-OH, *-SH, *-C(=O)-OH, *-C(=S)-OH, *-C(=O)-SH, *-C(=S)-SH, *-N(Q₅₁)(Q₅₂), or any combination thereof,
m in *-[C(R₃₁)(R₃₂)]ₘ-(R₃₃) is an integer from 1 to 30,
at least one *-C(R₃₁)(R₃₂)-*' in *-[C(R₃₁)(R₃₂)]ₘ-(R₃₃) is optionally substituted with *-O-*', *-S-*' or *-N(R₃₁)-*',
Q₄₁, Q₄₂, Q₅₁ and Q₅₂ are each independently hydrogen, a C₁-C₂₀ alkyl group, or a C₆-C₂₀ aryl group,
n is 0 or 1,
a1 is an integer from 0 to 10, and
each of * and *' indicates a binding site to a neighboring atom.

2. The cleaning composition of claim 1, wherein the solvent comprises water; and/or
wherein n in Formula 1B is 0.

3. The cleaning composition of claims 1 or 2, wherein, in Formula 1A, Y₂ is C(R₀)(R₁),
R₀ is *-OH or *-SH, and
R₁ is hydrogen.

4. The cleaning composition of any of claims 1-3, wherein, in Formula 1A, Y₂ is N(R₁), and
R₁ is hydrogen.

5. The cleaning composition of any of claims 1-4, wherein at least one of R₁ to R₄ in Formula 1B is:
*-C(=O)-O(Z₁₁) or *-C(=O)-O⁻(Z₁₂)⁺; or
a C₁-C₂₀ alkyl group substituted with *-C(=O)-O(Z₂₁) or *-C(=O)-O⁻(Z₂₂)⁺,
Z₁₂ is N(Q₁₁)(Q₁₂)(Q₁₃)(Q₁₄), and
Z₂₂ is N(Q₂₁)(Q₂₂)(Q₂₃)(Q₂₄).

6. The cleaning composition of any of claims 1-5, wherein the cleaning accelerator further comprises at least one of a compound represented by Formula 1A(1), a compound represented by Formula 1B(1), a compound represented by Formula 1P-1 and a compound represented by Formula 1P-2: 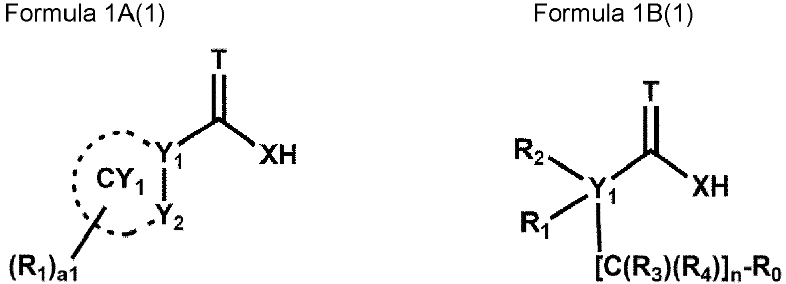
Formula 1P-1 A-OH
Formula 1P-2 N(Q₁)(Q₂)(Q₃)
wherein, T, X, A, ring CY₁, Y₁, Y₂, R₀ to R₄, Q₁ to Q₃, n, and a1 in Formulae 1A(1), 1B(1), 1P-1, and 1P-2 are each the same as described in claim 1, Y₁ in Formula 1A(1) is the same as described in connection with Y₁ in Formula 1A of claim 1, and Y₁ in Formula 1B(1) is carbon.

7. The cleaning composition of any of claims 1-6, wherein the cleaning accelerator comprises at least one of salts represented by Formulae 1C to 13C: 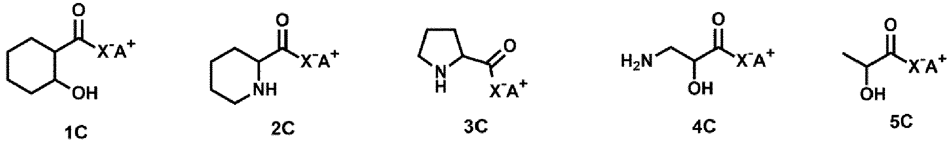 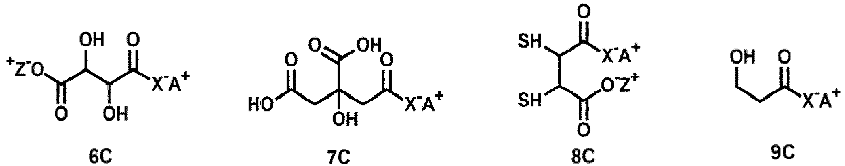 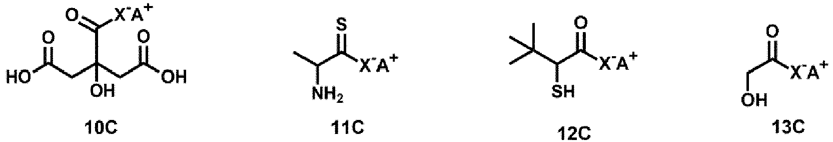
wherein, in Formulae 1C to 13C,
X and A are each the same as described in claim 1,
Z is hydrogen or N(Q₂₁)(Q₂₂)(Q₂₃)(Q₂₄), and
Q₂₁ to Q₂₄ are each the same as described in claim 1.

8. The cleaning composition of any of claims 1-7, wherein an amount of the cleaning accelerator is, per 100 wt% of the cleaning composition for removing residues on surfaces, in a range of 0.01 wt% to 10 wt%; and/or
wherein the cleaning composition further comprises a pH adjuster; and/or
wherein the cleaning composition does not comprise a fluorine-containing compound and an organic solvent.

9. The cleaning composition of any of claims 1-8, wherein
the residues on surfaces are, after a metal-containing film is surface-treated, separated from the metal-containing film and produced on the surface of the metal-containing film, and
the residues on surfaces comprise a metal derived from the metal-containing film;
preferably wherein the metal-containing film comprises aluminum, copper, titanium, tungsten, cobalt, or any combination thereof.

10. The cleaning composition of claim 9, wherein at least one of an anion represented by Formula 1A(2) and an anion represented by Formula 1B(2) is linked to a metal atom comprised in the residues on surfaces, and is not linked to a metal atom comprised in the metal-containing film: 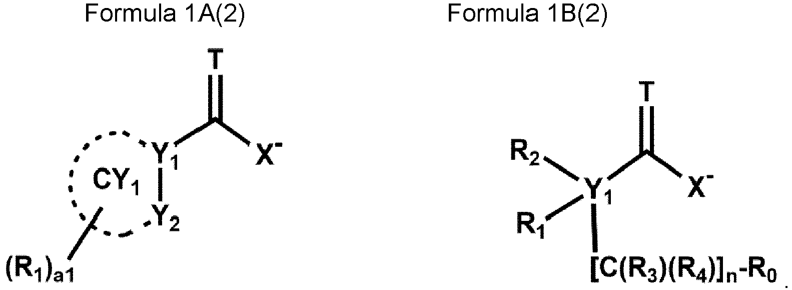 wherein, T, X, ring CY₁, Y₂, R₀ to R₄, n, and a1 in Formulae 1A(2) and 1B(2) are each the same as described in claim 1 Y₁ in Formula 1A(2) is the same as described in connection with Y₁ in Formula 1A of claim 1, and Y₁ in Formula 1B(2) is carbon.

11. A method of cleaning a metal-containing film, the method comprising:
preparing the cleaning composition for removing residues on surfaces according to any of claims 1-10; and
bringing the cleaning composition for removing residues on surfaces into contact with the metal-containing film provided on a substrate, the metal-containing film having a surface on which residues are generated.

12. The method of claim 11, wherein the preparing of the cleaning composition for removing residues on surfaces comprises preparing the cleaning accelerator by mixing at least one of the compound represented by Formula 1A(1) and the compound represented by Formula 1B(1) with at least one of the compound represented by Formula 1P-1 and the compound represented by Formula 1P-2: 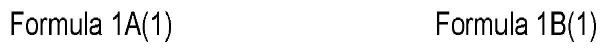 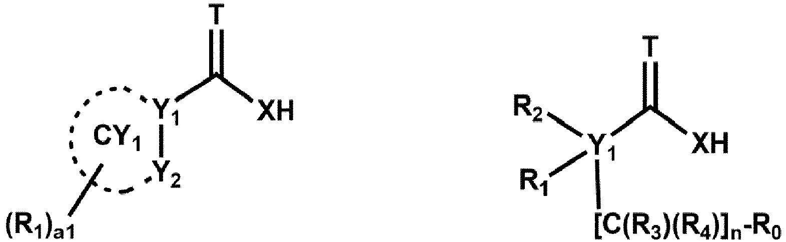
Formula 1P-1 A-OH
Formula 1P-2 N(Q₁)(Q₂)(Q₃)
wherein, T, X, A, ring CY₁, Y₂, R₀ to R₄, Q₁ to Q₃, n, and a1 in Formulae 1A(1), 1B(1), 1P-1, and 1P-2 are each the same as described in claim 1, Y₁ in Formula 1A(1) is the same as described in connection with Y₁ in Formula 1A of claim 1, and Y₁ in Formula 1B(1) is carbon.

13. The method of claims 11 or 12, wherein
the residues on surface are, after a metal-containing film is surface-treated, separated from the metal-containing film and produced on the surface of the metal-containing film,
the residues on surface comprise a metal derived from the metal-containing film, and
when the cleaning composition for removing residues on surfaces is brought into contact with the metal-containing film, at least one of the anion represented by Formula 1A(2) and the anion represented by Formula 1B(2) is linked to a metal atom comprised in the residues on the surface of the metal-containing film, and is not linked to a metal atom comprised in the metal-containing film: 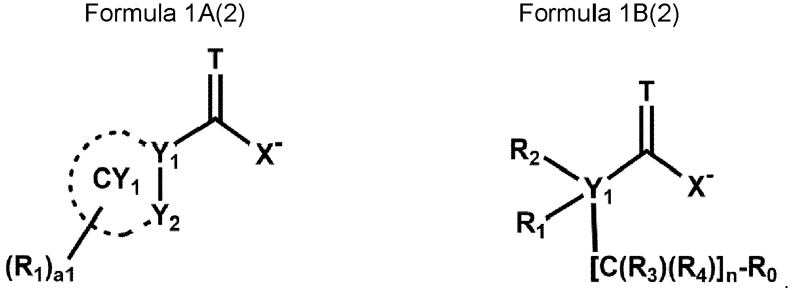
Wherein, T, X, ring CY₁, Y₂, R₀ to R₄, n, and a1 in Formulae 1A(2) and 1B(2) are each the same as described in claim 1, Y₁ in Formula 1A(2) is the same as described in connection with Y₁ in Formula 1A of claim 1, and Y₁ in Formula 1B(2) is carbon.

14. The method of any of claims 11-13, wherein the metal-containing film comprises aluminum, copper, titanium, tungsten, cobalt, or any combination thereof; and/or
wherein the method further comprises
washing the metal-containing film using an additional solvent, and optionally, removing the additional solvent by drying the metal-containing film.

15. A method of manufacturing a semiconductor device, the method comprising the method of any of claims 11-14.
